## Europäisches Patentamt

## European Patent Office

## Office européen des brevets

(11) Veröffentlichungsnummer: **0 081 188**
**B1**

(12) **EUROPÄISCHE PATENTSCHRIFT**

(45) Veröffentlichungstag der Patentschrift:
**11.03.87**

(51) Int. Cl.⁴: **H 05 K 7/10, H 01 R 23/72**

(21) Anmeldenummer: **82111069.9**

(22) Anmeldetag: **30.11.82**

(54) **Verbindungselement für Chipträger.**

(30) Priorität: **04.12.81 DE 3148018**

(43) Veröffentlichungstag der Anmeldung:
**15.06.83 Patentblatt 83/24**

(45) Bekanntmachung des Hinweises auf die Patenterteilung:
**11.03.87 Patentblatt 87/11**

(84) Benannte Vertragsstaaten:
**AT FR GB NL SE**

(56) Entgegenhaltungen:
**US - A - 3 665 370**
**US - A - 3 701 075**
**US - A - 3 753 211**
**US - A - 3 866 999**
**US - A - 3 910 664**

(73) Patentinhaber: **International Standard Electric Corporation, 320 Park Avenue, New York New York 10022 (US)**

(72) Erfinder: **Hartl, Walter, im Bürgle 15, D-7057 Winnenden 5 (DE)**

(74) Vertreter: **Gähr, Hans-Dieter, Dipl.-Ing. (FH) et al, c./o.Standard Elektrik Lorenz AG Patent- und Lizenzwesen Postfach 300 929 Kurze Strasse 8, D-7000 Stuttgart 30 (DE)**

## Beschreibung

Verbindungselemente der vorliegenden Gattung werden überwiegend in der Mikroelektronik verwendet.

Bei verschiedenen handelsüblichen Ausführungen sind die elektrischen Kontaktelemente in Kammern von rahmenartigen Fassungen oder Sockeln angeordnet. Diese weisen einen überhöhten Rand auf, der die Chipaufnahme umgrenzt. Mittels eines schwenkbar befestigten oder auch aufschnappbaren Rahmens, der mechanische Andruckfedern aufweist, wird der Chipträger mit seinen Kontaktflächen gegen die Federenden der Kontaktelemente angedrückt.

Es sind auch Verbindungselemente bekannt (EP-Anmeldung 0 030 763), bei denen zur Festlegung und Kontaktierung des Chipträgers anstelle eines Andruckrahmens mehrere, jeweils an einer Aussenseite des Isolierstoffrahmens schwenkbar befestigte Federblechstreifen vorgesehen sind.

Ein Verbindungselement für plattenförmige Chipträger gemäss dem Oberbegriff des Anspruchs 1 ist aus der US-A-3 753 211 bekannt. Es besteht aus einem leistenförmigen Isolierstoffrahmen mit je einer im Bereich der Rahmenlängsseiten angeordneten Reihe Kontaktelementen. Bei diesen handelt es sich im wesentlichen um ebene Blechstanzteile, die so in entsprechenden Kontaktkammern des Rahmens befestigt sind, dass die mit einer nach aussen gerichteten Ausbiegung versehenen Federschenkel in parallelem Abstand neben Seitenwänden des Rahmens frei hochstehen. Innerhalb einer jeden Reihe Kontaktelemente sind mehrere, die Federschenkel überragende Führungspfosten angeordnet, die den Chipträger beim Einsetzen in das Verbindungselement zentrieren. Zwischen die Führungspfosten und die Seitenwände des Rahmens werden die Seitenteile einer aufschnappbaren Abdeckkappe eingeführt, die einen reibenden Kontakteingriff zwischen den Federschenkeln der Kontaktelemente des Verbindungselementes und den Anschlussflächen des Chipträgers herstellen.

Der Erfindung liegt die Aufgabe zugrunde, ein einfaches und fertigungstechnisch kostengünstig herstellbares Verbindungselement für unterschiedlich dicke Chipträger zu schaffen, das eine dauerhafte, elastische Verbindung zwischen den auf dem Chipträger im Randbereich angeordneten Kontaktflächen und den Leitungszügen einer gedruckten Leiterplatte gestattet. Die Aufgabe wird erfindungsgemäss durch die im kennzeichnenden Teil des Anspruchs 1 angegebenen konstruktiven Massnahmen gelöst. Vorteilhafte Ausgestaltungen des Gegenstandes des Anspruchs 1 sind den Unteransprüchen zu entnehmen.

Die elektrischen Kontaktelemente lassen sich in vorteilhafter Weise aus einfachen Drahtabschnitten anfertigen, welche ohne Abfall von einer Vorratsrolle abgetrennt und gleichzeitig in einer einfachen Vorrichtung gebogen werden. Ausserdem werden sie bei der in einem Arbeitsgang erfolgenden Herstellung des Isolierstoffrahmens gleich mit eingespritzt. Durch die frei aufragenden Federschenkel und ihre den Chipträger an seinen Schmalseiten berührende Anordnung erfolgt ein selbsttätiger Ausgleich der herstellungsbedingten Längen-, Breiten- und Dickentoleranz des Chipträgers und zwar unabhängig von der möglichen Verwendung verschiedener Nominaldicken. Ausserdem erfolgt auch zwischen den Federschenkeln und den Anschlussflächen des Chipträgers ein seitlicher Toleranzausgleich. Der Chipträger wird überdies beim Einrasten der Federschenkel in seine halbkreisförmigen Ausschnitte zentriert. Werden die Federschenkel der Kontaktelemente mit den Anschlussflächen des Chipträgers gelötet, so bleiben die Federschenkel noch ausreichend elastisch, um bei Temperaturschwankungen das unterschiedliche Ausdehnungsverhalten der verschiedenen Werkstoffe nach allen Richtungen zu kompensieren. Weitere Vorteile sind in der Beschreibung erwähnt.

Ausführungsbeispiele der Erfindung werden anhand von Zeichnungen wie folgt näher erläutert. In den Zeichnungen zeigt:

Fig. 1 einen Ausschnitt des in eine Leiterplatte eingelöteten Verbindungselementes mit Chipträger, teilweise quergeschnitten;

Fig. 2 die Anordnung der Fig. 1, teilweise geschnitten, in der Draufsicht;

Fig. 3 und 4 die Anordnung der Fig. 1 mit unterschiedlich ausgebildeten Kontaktelemente-Anschlussenden;

Fig. 5 die Anordnung der Fig. 1 mit in der Z-Achse elastisch ausgebildetem Pfosten;

Fig. 5a die Anordnung der Fig. 5 in der Draufsicht;

Fig. 6 die Anordnung der Fig. 1 mit einem anderen Ausführungsbeispiel der elastischen Pfostenauflage des Chipträgers;

Fig. 6a die Anordnung der Fig. 6 in der Draufsicht.

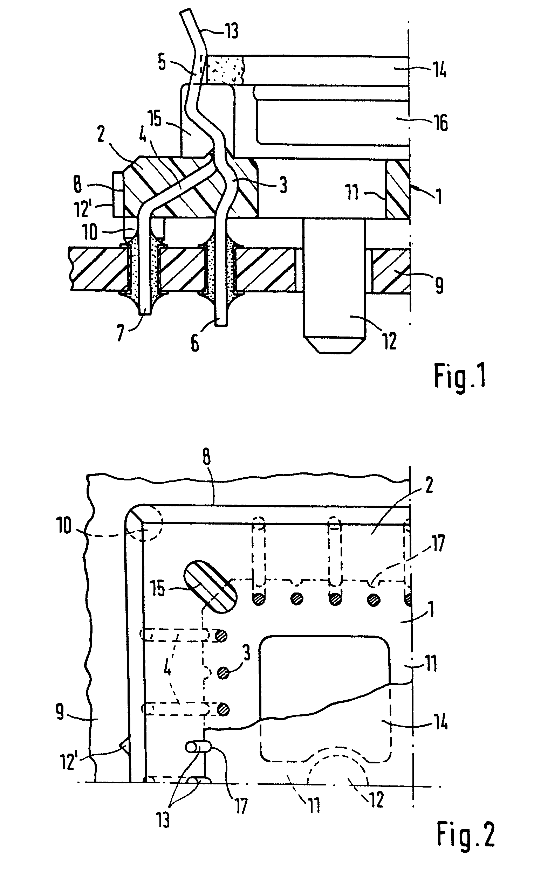

In den Fig. 1 bis 6 ist der Isolierstoffrahmen des Verbindungselementes mit 1 bezeichnet. Er wird vorzugsweise als einstückiges Spritzteil in quadratischer Konfiguration hergestellt, wobei seine Rahmenschenkel 2 einen im wesentlichen rechteckigen Querschnitt aufweisen. Letztere enthalten die beim Spritzen fest mit eingebetteten elektrischen Kontaktelemente 3, 4, welche aus einfachen Drahtabschnitten bestehen. Ihre auf der Rahmenoberseite austretenden Federschenkel 5 sind in einer Reihe und ihre auf der Rahmenunterseite austretenden Anschlussenden 6, 7 bei dem in Fig. 1 dargestellten Ausführungsbeispiel in zwei Reihen angeordnet.

Soll das Abstandsmass zwischen zwei benachbarten Anschlussenden 6, 7 noch grösser sein als bei der erwähnten zweireihigen Anordnung, so können in wechselnder Folge auch jeweils ein Anschlussende 6 an der Rahmenunterseite und das nächste seitlich an den Schmalseiten 8 des Isolierstoffrahmens 1 herausgeführt und ausserhalb der Rahmenschenkel 2 abgebogen sein.

Die Anordnung der Anschlussenden 6, 7 entspricht letztlich dem Anschlussraster auf der Leiterplatte 9, mit deren gedruckten Leitungszügen die Anschlussenden 6, 7 der Kontaktelemente 3, 4 üblicherweise durch Löten verbunden werden. Deshalb sind die Anschlussenden 6, 7, wie bei dem in Fig. 1 dargestellten Ausführungsbeispiel vorgesehen, gerade und sie werden zum Einlöten durch die entsprechenden Löcher der Leiterplatte 9 gesteckt oder sie werden zum Auflöten auf entsprechende Anschlussflächen der Leiterplatte entweder gemeinsam zum Rahmeninnern hin bzw. gemeinsam von den Rahmenschenkeln 2 weg oder auch in alternierender Anordnung im spitzen Winkel zur Leiterplattenebene abgebogen. Bei dem letztgenannten (nicht dargestellten) Ausführungsbeispiel der für die sogenannte Auflöttechnik ausgebildeten Anschlussenden, lässt sich eine noch grössere Loteinbettung erreichen, indem ihre Endabschnitte mit einer nochmaligen Biegung versehen werden, so dass diese Abschnitte auf den Anschlussflächen der Leiterplatten plan aufliegen.

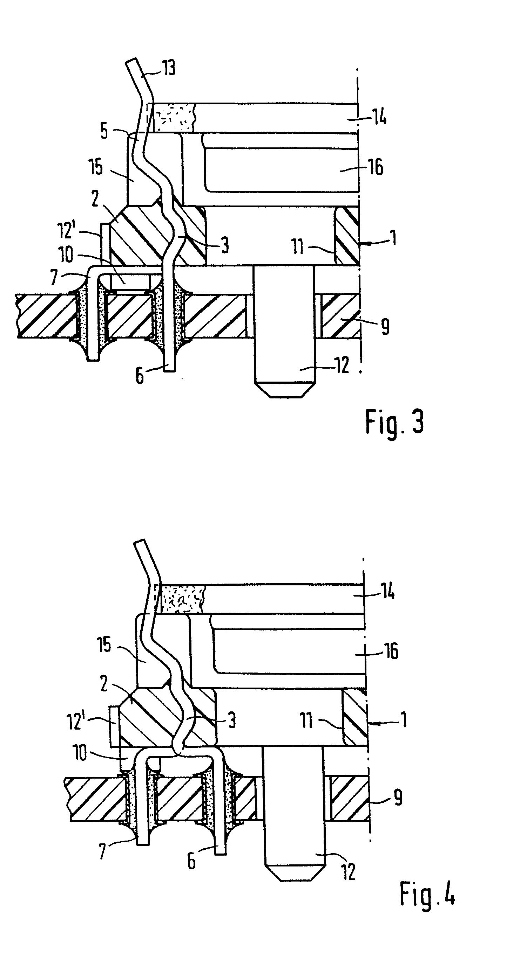

In den Rahmenschenkeln 2 können die Kontaktelemente 3, 4 natürlich auch alle so eingebettet sein, dass ihre Anschlussenden 6, 7 in nur einer Reihe an der Rahmenunterseite austreten und von denen dann abwechselnd eines gerade bleibt, während das nächste Anschlussende 7 unmittelbar an der Rahmenunterseite erst horizontal nach aussen und dann vertikal abgebogen ist (Fig. 3). Die erforderliche Festigkeit der Kontaktelementeeinbettung in den Rahmenschenkeln 2 wird durch eine Verformung des umspritzten Drahtabschnittes erreicht, der deshalb z.B. geriffelt, angequetscht oder gekröpft ist.

Wie Fig. 4 zeigt, können auch sämtliche Kontaktelemente 3, 4 unmittelbar an der Rahmenunterseite wechselweise so abgewinkelt sein, dass ein Anschlussende 6 zur Rahmeninnenseite und das andere Anschlussende 7 zur Rahmenaussenseite hin versetzt ist. Die Abbiegungen lassen sich dabei z.B. so anordnen, dass die zur Rahmeninnenseite führenden Biegeabschnitte eine zur vorderen Reihe schräg versetzte Lage einnehmen, so dass deren senkrechte Endabschnitte sich hinter denen der vorderen Reihe befinden. Die Anschlussenden 6, 7 sind somit auch in solche Lochbilder einsetzbar, die auf Leiterplatten für gebräuchliche Klemmsockel üblicherweise vorgesehen werden.

Um eine ganzflächige Berührung des Isolierstoffrahmens 1 mit der Leiterplatte 9 zu vermeiden, sind an der Rahmenunterseite mehrere Zapfen 10 angespritzt, vorzugsweise an jeder der vier äusseren Ecken einer, welche den gewünschten Abstand zur Leiterplatte 9 herstellen und die beim Löten einen ungehinderten Lotfluss gewährleisten. Ausserdem weist der Isolierstoffrahmen 1 innen zwei sich kreuzende Stege 11 auf, von denen einer an der Unterseite einen exzentrisch angeordneten Codierstift 12 trägt. Dieser wirkt wegen der unsymmetrischen Form des Isolierstoffrahmens 1 als Verdrehsicherung gegen falsches Einsetzen der Anschlussenden 6, 7 in das Lochbild der Leiterplatte 9 und sorgt damit für eine fehlerfreie Montage des Verbindungselementes. Ausserdem kann der Isolierstoffrahmen 1 mit einer angespritzten Nase 12' versehen sein, die als optische Codierhilfe dient. Vorzugsweise werden an den äusseren Schmalseiten 8 von zwei parallel verlaufenden Rahmenschenkeln 2 je eine Nase 12' vorgesehen.

Auf der Rahmenoberseite sind die Federschenkel 5 aller Kontaktelemente 3, 4 identisch ausgebildet. Damit sie in der Z-Achse, also senkrecht zur Rahmenebene, eine gewisse Elastizität erhalten, sind die Federschenkel gekröpft. Sofern keine besondere Elastizität in der Z-Achse erforderlich ist, können die Federschenkel 5 auch eine gestreckte Form aufweisen. Davon unabhängig sind die Endabschnitte 13 der Federschenkel 5 zur Rahmenaussenseite hin etwas zurückgebogen, so dass sie gemeinsam eine trichterförmige Einführung für den Chipträger 14 bilden. Bei den in den Zeichnungen dargestellten Ausführungsbeispielen sind die Federschenkel 5 der Kontaktelemente 3, 4 mit einer jeweils zur äusseren Schmalseite 8 gerichteten Ausbiegung versehen, an deren wieder einwärts gebogenen Abschnitt sich der schräg nach aussen gestellte Endabschnitt 13 anschliesst.

Der Chipträger 14 ist verfahrensbedingt an seinen vier äusseren Schmalseiten mit halbkreisförmigen Ausschnitten 17 versehen, deren Anordnung mit dem Teilungsabstand seiner auf der Ober- und Unterseite vorgesehenen Anschlussflächen übereinstimmt und mit denen die Ausschnitte 17 über einen Metallbelag elektrisch verbunden sind. Die Federschenkel 5 sind diesem Teilungsabstand entsprechend angeordnet und können daher beim Einsetzen eines Chipträgers 14 in dessen Ausschnitte 17 einrasten. Der Chipträger 14 wird vorzugsweise mit nach unten hängendem Chip 16 montiert. Dies hat den Vorteil, dass auf seine freie Rückseite Kühlkörper geklebt werden können. Die Einsetztiefe des Chipträgers 14 innerhalb der Federschenkel 5 wird beispielsweise durch auf die Rahmenschenkel 2 gelegte Klötzchen oder durch entsprechende Schieber einer Montagevorrichtung begrenzt, die nach den mittels Löten erfolgenden elektrischen und mechanischen Verbindungen von Federschenkeln 5 und Anschlussflächen wieder entfernt werden.

Bei den in den Zeichnungen dargestellten Ausführungsbeispielen des Isolierstoffrahmens 1 steht auf der Rahmenoberseite in den Gehrungsbereichen der Rahmenschenkel 2 jeweils ein Pfosten 15, welche zusammen eine Vierpunktauflage für den Chipträger 14 bilden. Die Länge der Federschenkel 5 ist im Hinblick auf die bekannten Dickenabmessungen der Chipträger so gewählt, dass sie die Pfosten 15 deutlich überragen. Beim Einsetzen eines Chipträgers 14 werden die Federschenkel 5 nach aussen etwas ausgelenkt, wodurch sie in den Ausschnitten 17 mit Druck anliegen. Dieser Federschenkelandruck ist in manchen Anwendungsfällen ausreichend, um die elektrische Verbindung zu den Anschlussflächen herzustellen und den Chipträger ausserdem noch mit Abstand zum Rahmen mechanisch selbsthemmend zu haltern. Ein schnelles Auswechseln von Chipträgern ist bei dieser Verbindungsart ohne weiteres möglich. Bei den häufigeren Verwendungsfällen wird jedoch eine feste Lotverbindung zwischen Federschenkel und entsprechender Anschlussfläche benötigt. Daher ist es zweckmässig, den Abstand zwischen dem sich an den geraden Endabschnitt 13 des Federschenkelendes unten anschliessenden ersten Biegeknick und der Pfostenauflagefläche so zu bemessen, dass der Biegeknick sich bei den dicksten der gebräuchlichen Chipträgerausführungen in der Montagelage etwas über deren oberer Plattenebene befindet. Hierdurch wird der Chipträger 14 bis zum Lötvorgang stets gegen die Auflageflächen der Pfosten 15 angedrückt.

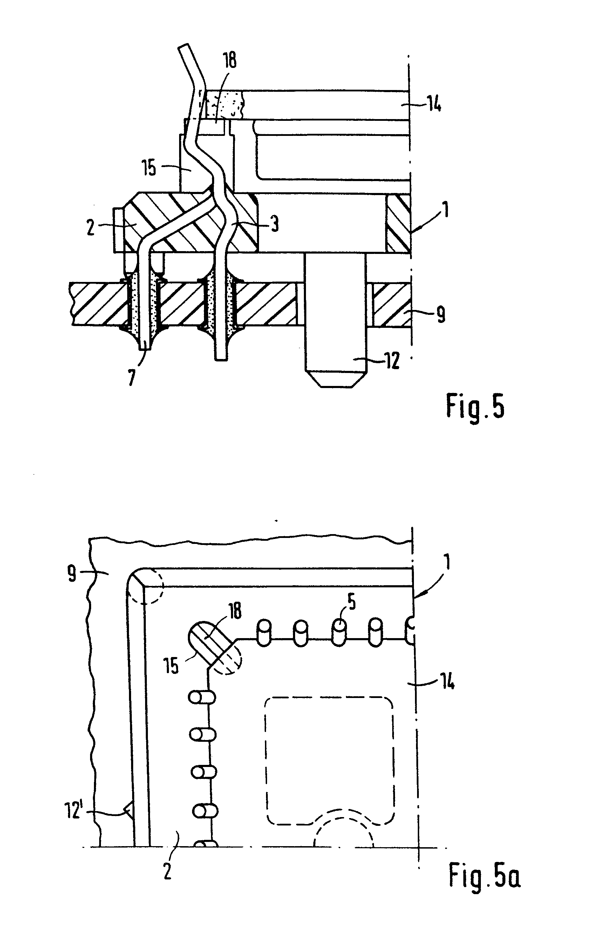

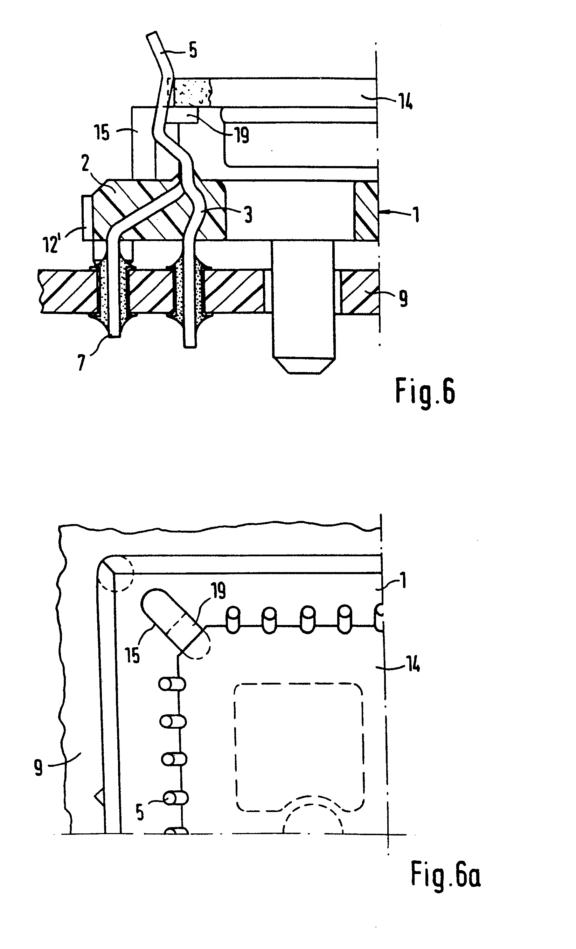

Wird eine über die Elastizität der Federschenkel 5 hinausgehende Flexibilität zwischen Chipträger 14 und Leiterplatte 9 in Richtung der Z-Achse gefordert, dann können die Pfosten 15 beispielsweise ihren Querschnitt schwächende Ausnehmungen oder Durchbrechungen aufweisen, so dass ihre Auflageflächen bei entsprechender Belastung nachgeben. Wie das Ausführungsbeispiel in den Fig. 5 und 5a zeigt, kann der Pfosten 15 auch aus einer mechanisch stabilen Basis mit oben als schmalem Steg 18 ausgeformter elastischer Auflage für den Chipträger 14 bestehen. Die Fig. 6 und 6a zeigen, dass die elastische Ausbildung der Auflage unter anderem auch mittels einer vom Pfosten 15 seitlich abstehenden Zunge 19 realisierbar ist.

## Patentansprüche

1. Verbindungselement für plattenförmige Chipträger (14), die am Plattenrand an den äusseren Schmalseiten (8) des Chipträgers (14) endende Anschlussflächen aufweisen, an welche die hochstehenden Federschenkel (5) von in einem Isolierstoffrahmen (1) des Verbindungselementes befestigten elektrischen Kontaktelementen (3, 4) seitlich anlegbar sind, deren an der Unterseite aus dem Rahmen (1) hervorstehende Anschlussenden (6, 7) mit einer gedruckten Leiterplatte (9) verbindbar sind, dadurch gekennzeichnet, dass die Kontaktelemente (3, 4) aus einfachen, in den Isolierstoffrahmen (1) fest eingespritzten Drahtabschnitten bestehen, von denen die Federschenkel (5) zur Rahmenaussenseite hin zurückgebogene Endabschnitte (13) aufweisen, die eine trichterförmige Einführung für den Chipträger (14) bilden, und welche die Federschenkel (5) beim Einsetzen eines Chipträgers (14) in das Verbindungselement auslenken, so dass ein jeweils unterhalb des Endabschnittes (13) anschliessender erster Biegeknick in einen der an den äusseren Schmalseiten (8) des Chipträgers (14) vorhandenen Ausschnitte (17) einrastet und die Federschenkel (5) durch Löten mit den in den Ausschnitten (17) befindlichen Anschlussflächen verbindbar sind.

2. Verbindungselement nach Anspruch 1, dadurch gekennzeichnet, dass die Drahtabschnitte der Kontaktelemente (3, 4) innerhalb der Rahmenschenkel (2) verformt sind.

3. Verbindungselement nach Anspruch 1, dadurch gekennzeichnet, dass die frei hochstehenden Federschenkel (5) über dem Isolierstoffrahmen (1) wenigstens eine Ausbiegung aufweisen.

4. Verbindungselement nach Anspruch 1 bis 3, dadurch gekennzeichnet, dass die auf der Rahmenoberseite austretenden Federschenkel (5) der Kontaktelemente (3, 4) in einer Reihe und ihre auf der Rahmenunterseite austretenden Anschlussenden (6, 7) in zwei Reihen angeordnet sind.

5. Verbindungselement nach Anspruch 1 bis 4, dadurch gekennzeichnet, dass der Isolierstoffrahmen (1) auf der Rahmenoberseite mit mehreren Pfosten (15) für die Auflage eines Chipträgers (14) versehen ist und dass die hochstehenden Federschenkel (5) der Kontaktelemente (3, 4) die Pfosten (15) überragen.

6. Verbindungselement nach Anspruch 1 und 5, dadurch gekennzeichnet, das der an den geraden Endabschnitt (13) des Federschenkelendes anschliessende erste Biegeknick bei auf den Pfosten (15) des Isolierstoffrahmens (1) liegendem Chipträger (14) sich über dessen oberer Plattenebene befindet.

7. Verbindungselement nach Anspruch 5 und 6, dadurch gekennzeichnet, dass die Pfosten (15) des Isolierstoffrahmens (1) in den Gehrungsbereichen seiner Rahmenschenkel (2) angeordnet sind.

8. Verbindungselement nach einem der Ansprüche 5 bis 7, dadurch gekennzeichnet, dass der Pfosten (15) in der Längsachse elastisch ist.

9. Verbindungselement nach einem der Ansprüche 5 bis 8, dadurch gekennzeichnet, dass der Pfosten (15) an seinem freien Ende zu einem schmalen Steg (18) ausgeformt ist.

10. Verbindungselement nach Anspruch 1 bis 7, dadurch gekennzeichnet, dass der Isolierstoffrahmen (1) an seiner Unterseite mit mehreren als Abstandshalter dienenden Zapfen (10) versehen ist.

11. Verbindungselement nach einem der Ansprüche 1 bis 7, dadurch gekennzeichnet, dass der Isolierstoffrahmen (1) innen zwei sich kreuzende Stege (11) enthält.

12. Verbindungselement nach Anspruch 11, dadurch gekennzeichnet, dass einer der Stege (11) an seiner Unterseite einen exzentrisch angeordneten Codierstift (12) aufweist.

13. Verbindungselement nach einem der Ansprüche 1 bis 7, 10 und 11, dadurch gekennzeichnet, dass der Isolierstoffrahmen (1) an wenigstens einer Schmalseite (8) mit einer angespritzten Nase (12') versehen ist.

## Claims

1. Connection element for plate-shaped chip carriers (14) having connecting surfaces ending at the edge of the plate at the outer narrow sides (8) of the chip carrier (14), against which surfaces the upstanding spring legs (5) of electrical contact elements (3, 4) secured in a frame (1) of insulating material of the connecting element can be laterally applied, the connecting ends (6, 7) projecting at the bottom from the frame (1) being capable of being connected to a printed circuit board (9), characterized in that said contact elements (3, 4) consist just of wire cuttings firmly injection-moulded into said frame (1) of insulating material, said spring legs (5) of said contact elements having end sections (13) bent back towards the outer side of said frame forming a funnel-shaped introduction for said chip carrier (14) and deflecting said spring legs (5) when a chip charrier (14) is being inserted into the connecting element, so that a first kink adjacent in each case to the end section (13) locks into one of the recesses (17) on the outer narrow sides (8) of said chip carrier (14) and said spring legs (5) are capable of being soldered to the connecting surfaces in said recesses (17).

2. A connecting element as claimed in Claim 1, characterized in that the wire sections of said contact elements (3, 4) are deformed within said frame piece (2).

3. A connecting element as claimed in Claim 1, characterized in that said freely upstanding spring legs (5) have at least one bent-out portion above said pin frame (1) of insulating material.

4. A connecting element as claimed in Claims 1 to 3, characterized in that said spring legs (5) of said contact elements (3, 4) are arranged in one row and its connecting ends (6, 7) projecting on the bottom side of said pin frame are arranged in two rows.

5. A connecting element as claimed in Claims 1 to 4, characterized in that said pin frame (1) of insulating material is provided, on the top side of said frame, with several posts (15) for supporting a chip carrier (14) and that said upstanding spring legs (5) of said contact elements (3, 4) project over said posts (15).

6. A connecting element as claimed in Claims 1 and 5, characterized in that the first kink adjacent to the straight end section (13) of the end of said spring leg is situated, when said chip carrier (14) is lying on said posts (15) of said pin frame (1) of insulating material, over the upper plate surface thereof.

7. A connecting element as claimed in Claims 5 and 6, characterized in that said posts (15) of said pin frame (1) of insulating material are arranged in the mitre-joint areas of the frame pieces (2) thereof.

8. A connecting element as claimed in any one of Claims 5 to 7, characterised in that said post (15) is flexible in its longitudinal axis.

9. A connecting element as claimed in any one of Claims 5 to 8, characterized in that said post (15) is shaped at its free end to form a narrow web (18).

10. A connecting element as claimed in any one of Claims 1 to 7, characterized in that said pin frame (1) of insulating material is provided on its bottom side with several studs (10) serving as spacing elements.

11. A connecting element as claimed in any one of Claims 1 to 7, characterized in that said pin frame (1) of insulating material contains within it two webs (11) crossing each other.

12. A connecting element as claimed in Claim 11, characterized in that one of said webs (11) is provided on its bottom side with an eccentrically arranged coding pin (12).

13. A connecting element as claimed in any one of Claims 1 to 7, 10 and 11, characterized in that said pin frame (1) of insulating material is provided on at least one narrow side (8) with a nose member (12') which is injection-moulded thereto.

**Revendications**

1. Elément de raccordement pour supporte de puce en forme de plaques (14) présentant sur le bord de la plaque des surfaces de raccordement se terminant sur le chant externe (8) du support de puce (14), sur lesquelles peuvent venir s'appuyer latéralement les branches élastiques (5) s'étendant vers le haut d'éléments de contact électriques (3, 4) fixés dans un cadre en matériau isolant (1) de l'élément de raccordement, dont des extrémités de raccordement (6, 7) dépassant de la face inférieure du cadre (1) peuvent être connectées à une carte à circuits imprimés (9), caractérisé en ce que les éléments de contact (3, 4) consistent simplement en des section de fil fixées par surmoulage dans le cadre en matériau isolant (1) dont les branches élastiques (5) comportent des parties terminales (13) cambrées en arrière à partir de la face externe du cadre, constituant un entonnoir d'entrée pour le support de puce (14), ces branches élastiques (5) s'écartant à l'insertion d'un support de puce (14) dans l'élément de raccordement, de manière telle qu'un premier bossage faisant suite vers le bas à chaque partie terminale (13) respective s'engage dans une des encoches (17) existant dans le chant externe (8) du support de puce (14) et que les branches élastiques (5) puissent être connectées par brasage aux surfaces de raccordement se trouvant dans les encoches (17).

2. Elément de raccordement selon la revendication 1, caractérisé en ce que les sections de fil des éléments de contact (3, 4) sont déformées à l'intérieur des parties de cadre (2).

3. Elément de raccordement selon la revendication 1, caractérisé en ce que les branches élastiques (5) s'étendant vers le haut librement comportent au moins un bossage au-dessus du cadre (1) en matériau isolant.

4. Elément de raccordement électrique selon les revendications 1 à 3, caractérisé en ce que les branches élastiques (5) des éléments de contact (3, 4) dépassant de la surface supérieure du cadre sont disposées en une rangée, tandis que leurs extrémités de raccordement qui dépassent de la surface inférieure du cadre sont disposées en deux rangées.

5. Elément de raccordement selon les revendications 1 à 4, caractérisé en ce que le cadre en matériau isolant (1) est pourvu de plusieurs piliers (15), du côté supérieur du cadre, pour porter le support de puce (14) et en ce que les branches élastiques (5) s'étendant vers le haut des éléments de contact (3, 4) dépassent de ces piliers (15).

6. Elément de raccordement selon les revendications 1 et 5, caractérisé en ce que le premier bossage faisant suite à la partie terminale droite (13) des extrémités des branches élastiques se trouve, par rapport au support de puce (14) reposant sur les piliers (15) du cadre en matière isolante (1), au dessus du plan supérieur de sa plaque.

7. Elément de raccordement selon les revendications 5 et 6, caractérisé en ce que les piliers (15) du cadre en matériau isolant (1) sont disposés dans les zones de jonction des parties du cadre (2).

8. Elément de raccordement selon les revendications 5 à 7, caractérisé en ce que les piliers (15) sont flexibles selon leur axe longitudinal.

9. Elément de raccordement selon les revendications 5 à 8, caractérisé en ce que les piliers (15) ont leur extrémité libre conformée en une paroi étroite (18).

10. Elément de raccordement selon les revendications 1 à 7, caractérisé en ce que le cadre en matériau isolant (1) est pourvu à sa partie inférieure de plusieurs pions servant d'éléments d'espacement.

11. Elément de raccordement selon les revendications 1 à 7, caractérisé en ce que ledit cadre en matériau isolant (1) est pourvu intérieurement de deux parois en croix (11).

12. Elément de raccordement selon la revendication 11, caractérisé en ce que l'une de ces parois (11) est pourvue, à sa partie inférieure, d'un pion de détrompage disposé de façon décentrée.

13. Elément de raccordement selon l'une quelconque des revendications 1 à 7, 10 et 11, caractérisé en ce que ledit cadre en matériau isolant (1) est pourvu, sur au moins un de ses côtés latéraux d'un nez (12') venu de moulage.

Fig.1

Fig.2

Fig. 3

Fig. 4

Fig.5

Fig.5a

11

Fig.6

Fig.6a